(19) Europäisches Patentamt
European Patent Office
Office européen des brevets

(11) Publication number: **0 361 907 A2**

# (12) EUROPEAN PATENT APPLICATION

(21) Application number: **89309860.8**

(51) Int. Cl.[5]: **G03F 7/004**

(22) Date of filing: **28.09.89**

(30) Priority: **29.09.88 US 250867**

(43) Date of publication of application: **04.04.90 Bulletin 90/14**

(84) Designated Contracting States: **AT BE CH DE ES FR GB GR IT LI LU NL SE**

(71) Applicant: **HOECHST CELANESE CORPORATION**
**Route 202-206 North**
**Somerville, New Jersey(US)**

(72) Inventor: **Usifer, Douglas A.**
**58 Ludlow Avenue**
**Belle Mead New Jersey(US)**
Inventor: **Kelly, Michael G.**
**12 Juniper Hill Drive**
**Coventry Rhode Island(US)**

(74) Representative: **De Minvielle-Devaux, Ian Benedict Peter et al**
**CARPMAELS & RANSFORD 43, Bloomsbury Square**
**London WC1A 2RA(GB)**

## (54) Photoresist compositions for deep UV image reversal.

(57) A photolithographic resist with sensitivity to the deep ultraviolet region which can produce both positive-tone and extremely high contrast negative-tone images is prepared from (1) an organic film-forming material, (2) an oxime sulfonate ester which releases a sulfonic acid on exposure to deep ultraviolet radiation, and (3) an additive which can both crosslink the film-forming material in the presence of heat with a catalytic amount of acid and also increase the photospeed in the positive mode. A process for the formation of both positive-tone and negative-tone images is also disclosed comprising (1) exposing the above composition to deep ultraviolet radiation in a pre-determined pattern and (2) treating the composition with aqueous base developer to remove the exposed areas and produce a positive-tone image, or (3) post-exposure baking and deep UV flood exposing the composition and then removing the unexposed, non-image areas with aqueous base developer to produce a negative-tone image. The image-forming process may be used in the production of printing plates and microelectronic circuits.

EP 0 361 907 A2

## BACKGROUND OF THE INVENTION

The present invention relates to deep ultraviolet radiation-sensitive photoresist compositions comprised of a) an aqueous alkali soluble organic film-forming material, b) a compound containing an oxime sulfonate ester which liberates a sulfonic acid on exposure to deep ultraviolet radiation, and c) an additive which serves both as a photospeed enhancer in the positive mode and as a crosslinking agent for the negative mode.

In the production of an image using a positive photoresist, the portions of the resist that are exposed to actinic radiation become more soluble in or more easily removed by a developer compared to the unexposed regions. Removal of the exposed regions by means of a developer, leaving the unexposed areas intact, results in the production of a positive image.

Generally commercially available positive photoresist compositions contain, in addition to an organic film-forming material which is usually a phenol-formaldehyde (novolac) resin, an o-naphthoquinone diazide compound which decomposes on exposure to actinic radiation to produce an indene carboxylic acid with the evolution of nitrogen. Before exposure, the o-naphthoquinone diazide acts as a dissolution inhibitor for the organic film-forming material. Upon exposure, however, the diazide is decomposed and completely loses its ability to act as an inhibitor and, in fact, becomes a dissolution enhancer. Thus, the dissolution rate of the exposed area becomes greater compared to that of the non-exposed areas.

The properties of a photoresist composition which are important in commercial practice include the photospeed of the resist, development contrast, resist resolution, and resist adhesion. The contrast of a photoresist is a direct reflection on the resist's potential resolution capabilities (for a definition of contrast, see UV Curing: Science and Technology, S. P. Pappas, Ed., page 333, Technology Marketing Corp., 1978). High contrast values therefore indicate high resolution capabilities. In general, the common positive-working organic photoresist gives contrast values of 2-4. Resist resolution refers to the capacity of a resist system to reproduce the smallest equally spaced line pairs and intervening spaces of a mask, utilized during exposure with a high degree of image edge acuity in the developed exposed areas.

The ability of a photoresist to produce very small dimensions, on the order of one micron or less, is extremely important in the manufacture of very large scale integrated silicon chips or similar components. Circuit density on such chips, assuming photolithographic techniques are utilized, can only be increased by increasing the resolution capabilities of the photoresist.

Deep ultraviolet (short wavelength), high-energy radiation is much more advantageous in this regard due to its ability to produce greater resolution compared to mid or near UV (long wavelength) radiation. Thus, photoresist compositions sensitive to deep UV radiation are very attractive materials for integrated electronics.

Photoresists are generally categorized as being either positive working or negative working. In a negative working resist composition, the imagewise light struck areas harden and form the image areas of the resist after removal of the unexposed areas with a developer. In a positive working resist the exposed areas are the non-image areas. The light struck parts are rendered soluble in aqueous alkali developers. While negative resists are the most widely used for industrial production of printed circuit boards, positive resists are capable of much finer resolution and smaller imaging geometries. Hence, positive resists are the choice for the manufacture of densely packed integrated circuits.

In many commercial applications, it is desirable to convert a positive working system for a negative working application; this process is called image reversal.

There is interest in the field of image reversal because of the utility of this process in practical device manufacturing. Among the practical aspects of image reversal are the elimination of the need for a dual set of complementary masks to do both positive and negative imaging, greater resolution and process latitude than with positive imaging alone, reduction in standing wave effects, and higher thermal stability. Several methods have been suggested for such image reversal, almost all being based on naphthoquinone diazide type photoresist compositions employing mid or near UV radiation. U.S. application 764,700 filed Aug. 12, 1985, describes a system comprised of novolak resin, a naphthoquinone diazide, and a crosslinking compound. This system, which is an effective positive working photoresist composition, can be made to image reverse by heating the coated substrate, after image-wise exposure, to effect acid-catalyzed crosslinking in the exposed regions. Following a flood exposure and development with aqueous base, a negative image is produced.

The above disclosure, however, suffers from several disadvantages. Foremost among these drawbacks

is the very strong absorption of the naphthoquinone diazide sensitizer in the preferred deep UV region. Because they absorb very strongly in the preferred deep ultraviolet region, photoresist compositions employing these diazides are relatively opaque to deep UV radiation and thus can produce inferior images. This problem results because the radiation cannot penetrate deeply into the photoresist coating. In addition, the naphthoquinone diazides are thermally unstable. The diazides decompose at elevated temperatures (>200° C), even with protection from actinic radiation. This potential to decompose at elevated temperatures renders the production of a quality image at high processing temperatures impossible.

U.S. Patent No. 4,491,628 issued January 1, 1985 describes the use of cationic photoinitiators to cleave polymer pendent carbonate groups. This cleavage alters the structure of the recurrent units to such an extent to create a solubility difference in the exposed and unexposed areas of the polymer film. This system, however, depends on the choice of developer in determining positive mode or negative mode behavior. In fact, to obtain a negative image with the above system, undesirable organic solvent must be employed as developer.

European Patent Application No. 0 241 423 published October 14, 1987 describes positive working compositions comprised of oxime sulfonate esters and alkali soluble organic film-forming materials. Although, this composition is reported to produce a quality image after image-wise ultraviolet exposure and aqueous alkaline development, no data were provided concerning such important parameters are photospeed, contrast, and resolution.

It is the object of this invention to provide new photoresist compositions which possess high sensitivity to the deep ultraviolet region, producing quality, fully aqueous-base developable positive or negative images after exposure in a pre-determined pattern. Positive or negative images can be obtained from the same formulation depending solely on whether or not a post-exposure bake is employed. This feature provides the end user with a very versatile deep UV resist system, adaptable to specific user needs. The contrast values obtainable employing this system in the negative mode are surprisingly high, with values between 8 and 16. These extremely high contrast values indicate the resist materials of this invention to have extraordinary resolution capabilities. In addition, the dissolution inhibitor of this invention is highly stable toward thermal degradation. This advantage allows for the production of high quality images at relatively high processing temperatures. Still another advantage of the present invention over the conventional o-naphthoquinone diazide-type systems is that the oxime sulfonate ester inhibitor compounds have little or no absorption of light in the conventional UV range (above 300 nm) and hence require no optical filters to obtain the higher resolution images available employing only shorter wavelength (deep UV) radiation.

The present invention relates to radiation-sensitive photoresist compositions comprising:

(A) a film-forming organic material and

(B) an oxime sulfonate ester which liberates a sulfonic acid on exposure to deep ultraviolet radiation, the composition being substantially free from ethylenically unsaturated material which is polymerizable by means of free radicals, and

(C) a compound that can:

1. crosslink the film-forming organic material in the presence of acid and heat, and also

2. increase the photospeed in the positive mode relative to an analogous photoresist without said compound.

A further aspect of this invention is a process for the production of positive or negative images comprising:

(i) exposing to deep ultraviolet radiation in a predetermined pattern, a composition supported on a substrate, which composition comprises:

(A) a film-forming organic material and

(B) an oxime sulfonate ester which liberates a sulfonic acid on exposure to deep ultraviolet radiation and

(C) a compound that can:

1. crosslink the film-forming organic material in the presence of acid and heat, and also

2. increase the photospeed in the positive mode relative to an analogous photoresist without said compound, and

(ii) obtaining a positive image by removing the exposed areas with aqueous base developer, the solubility in the exposed areas being enhanced by the presence of the photogenerated sulfonic acid and the photospeed enhancing compound or

(iii) obtaining a negative image by

(A) employing a post-exposure bake to effect acid catalyzed crosslinking in the exposed areas and

(B) flood exposing the composition with deep UV radiation and

(C) removing the unexposed non-image areas with aqueous base developer.

The oxime sulfonate esters which liberate a sulfonic acid on exposure to deep UV radiation are typically of the formula:

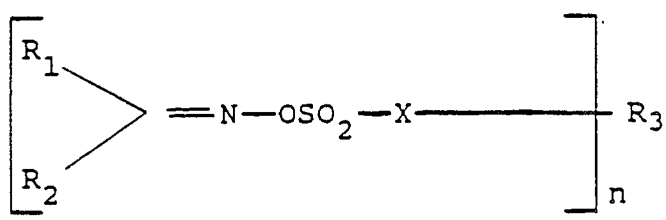

I

AND

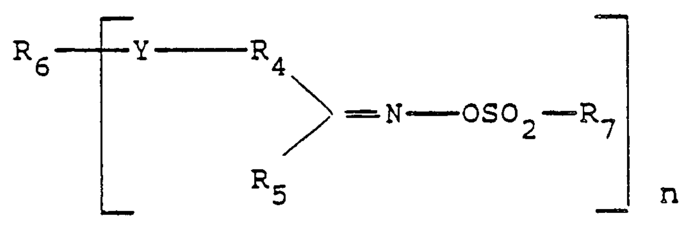

II

where
n is 1 or 2, preferably 1,
$R_1$ is -COO alkyl or -COO aryl or preferably -CN, and
$R_2$ is alkyl or aryl, preferably phenyl unsubstituted or substituted by $C_1$-$C_6$ alkyl,-OH, -CN, $C_1$-$C_4$-alkoxy, aryloxy, -COO aryl or -COO alkyl, or $NO_2$ or
$R_2$ and $R_1$ together with the atom to which they are bound form a $C_5$-$C_{10}$ carbocyclic or heterocyclic ring; and
X and Y are independently selected form a direct bond, or they are $-CH_2-$ or $C_2$-$C_5$ alkylene unsubstituted or substituted.

$R_3$ is, when n=1, $C_1$-$C_{18}$-alkyl, most preferably methyl or phenyl which may be unsubstituted or substituted by -OH, CN, halogen, $C_1$-$C_{12}$-alkyl, $C_1$-$C_4$-alkoxy, or $NO_2$; or it is naphthyl which is optionally substituted, or $R_3$ and $R_2$, or $R_3$ and $R_1$ together with the atoms to which they are bonded form a $C_5$-$C_{12}$ heterocyclic ring, and $R_3$ is, when n=2, a $(CH_2)_m$ group, wherein m is 2 to 8, or phenylene or naphthylene each optionally substituted.

$R_4$ represents arylene, preferably, phenylene, or it is a substituted arylene, methylene, $C_2$-$C_6$ straight, branched, or cyclic alkylene; and
$R_5$ is preferably cyano, or it represents a -COO alkyl or -COO aryl group.

$R_6$ is, when n=1, preferably a hydrogen atom, or it represents $C_1$-$C_8$ alkyl, or phenyl, phenyl substituted with -OH, CN, $C_1$-$C_4$ alkoxy, aryloxy, -COO alkyl, -COO aryl, $NO_2$, or halogen; or $R_5$ and $R_6$ together with the atoms to which they are bound form a $C_6$-$C_{12}$ carbocyclic or heterocyclic ring.

$R_7$ is preferably phenyl unsubstituted or substituted by -OH, CN, alkoxy, or halogen, or $C_1$-$C_5$ alkyl, preferably methyl, or it represents $C_1$-$C_{18}$ straight or branched alkyl which may be substituted or unsubstituted; or it is $C_6$-$C_{12}$ aryl, optionally substituted, or $R_7$ and $R_6$ or $R_5$ and $R_7$, together with the atoms to which they are bound, form a $C_6$-$C_{12}$ heterocyclic ring.

In the preferred photoresist composition, the oxime sulfonate ester is present in the formulation in an amount of from about 0.2 to about 11 weight percent of the solid components of the layer, more preferably from about 5 to about 9 weight percent, and most preferably from about 6 to about 8 weight percent.

European Patent No. 0 139 609 B1 issued February 4, 1987 describes systems of the above type employed as curing agents for lacquers.

The oxime sulfonate esters of the invention can be easily prepared in good yield by reaction of a compound bearing oxime functionality with a compound bearing sulfonyl chloride functionality in the presence of a suitable base, such as pyridine, or triethylamine, or N-methylmorpholine, in a suitable organic solvent, such as N-methylpyrrolidinone, N,N-dimethylacetamide, N,N-dimethyformamide, methylene chloride, tetrahydrofuran, propylene glycol methyl ether acetate. Additionally, the reaction is carried out in a solvent that can also act as a base, such as pyridine. The product can be precipitated from the reaction

mixture by the addition of the reaction mixture to a solvent, which is being stirred, that is miscible with the reaction solvent, yet immiscible with the desired product. Such a procedure can be exemplified by the addition of an N-methylpyrrolidinone solvent reaction mixture into water that is being agitated or stirred. Alternatively, the product could be isolated by washing an organic reaction mixture with water to remove water miscible salts and then evaporating the organic solvent to dryness to recover the desired product. The oxime sulfonate esters obtained from this procedure are usually recrystallized from a suitable solvent; however, the product obtained from the reaction mixture before recrystallization is usually sufficiently pure for use in the present invention. The starting oxime containing compound, if not available from commercial chemical suppliers, can be easily prepared by conventional synthetic procedures. Examples of these types of preparations may be found in "The Systematic Identification of Organic Compounds," John Wiley and Sons, New York, 1980, p. 181, or Die Makromoleculare Chemie, 1967, 108, 170, or Organic Synthesis, 1979, 59, 95.

The organic film-forming material which is soluble in aqueous base is preferably one containing phenolic hydroxyl groups.

Such film-forming materials include novolak resins which are prepared from an aldehyde such as acetaldehyde or furaldehyde, preferably formaldehyde, with a phenol such as phenol itself, phenol substituted by 1 or 2 chlorine atoms, such as p-chlorophenol, or 1 or 2 alkyl groups of 1 to 9 carbon atoms each, e.g., o-, m-, p-cresol, the xylenols, p-tert.butyl phenol, and p-nonylphenol, p-phenylphenol, resorcinol, bis(4-hydroxy-phenyl)methane, and 2,2-bis(4-hydroxyphenyl)methane.

Other suitable film-forming materials include homopolymers and copolymers of ethylenically unsaturated hydroxy aromatic derivatives. These materials include preferably homopolymers and copolymers of hydroxystyrene and phenyl ring-substituted hydroxystyrene.

In the preferred photoresist composition, the organic film forming material is present in the formulation in an amount of from about 84 to about 98 weight percent of the solid components of the composition, more preferably from about 86 to about 95 weight percent, and most preferably from about 87 to about 91 weight percent.

The additive component is a compound, which when in the presence of heat and a catalytic amount of acid, is capable of crosslinking the foregoing novolak or poly(vinylphenol) resin. This compound also has the capability of increasing the photospeed in the positive mode.

Additives suitable for use in the present invention have the general formula

$RO\text{-}CH_2\text{-}A\text{-}CH_2\text{-}OR$

wherein A is a monomeric, aromatic hydrocarbon having one or more fused or unfused, separated or unseparated rings and each R unit is independently H, ($C_1$-$C_6$) alkyl, ($C_3$-$C_6$) cycloalkyl aryl or arylalkyl.

In the preferred embodiment the additive compound has the formula

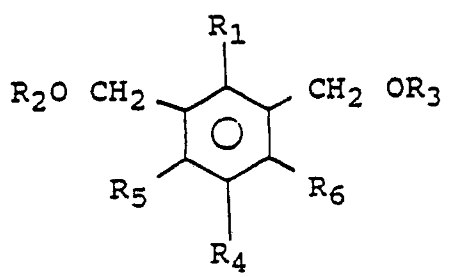

wherein $R_1$, $R_4$, $R_5$, $R_6$ are independently H, ($C_1$-$C_6$) alkyl, ($C_3$-$C_6$) cycloalkyl, aryl, arylalkyl or $OR_2$; and $R_2$, $R_3$ are independently H, ($C_1$-$C_6$) alkyl, ($C_3$-$C_6$) cycloalkyl, aryl or arylalkyl.

The preferred compounds are dimethylol paracresol as described in U.S. 4,404,272 which is incorporated by reference, and its ether and ester derivatives including phenol, 2,6-bis(hydroxyethyl)-4-methyl; benzene, 1-methoxy-2,6-bis-(hydroxymethyl-4-methyl; phenol, 2,6-bis(methoxymethyl)-4-methyl; and benzene, 1-methoxy-2,6-bis(methoxymethyl)-4-methyl; methyl methoxy diphenyl ether, melamine formaldehyde resins and compounds and alkylated analogous thereof having 1 to about 3 monomer units such as those typically sold under the trade names Cymel from American Cyanamid and Resimene from the Monsanto Company, for example hexamethylol melamine hexamethyl ether.

In the preferred photoresist composition, the additive compound is present in the formulation in an amount of from about 0.5 to about 7 weight percent of the solid components of the composition, more preferably from about 2 to about 6 weight percent, and most preferably from about 3 to about 5 weight percent.

The process of this invention is carried out by first coating a layer of the photosensitive composition of the invention onto a substrate from a solvent, such as N-methylpyrrolidinone, methyl ethyl ketone, cyclopentanone, propylene glycol mono methyl ether acetate, 2-ethoxy ethyl acetate, N,N-dimethylformamide, or mixtures thereof, in a conventional manner, such as by dip, roll, spray coating, or preferably spin coating. The residual solvent is evaporated either by air-drying or heating, optionally under reduced pressure. The substrate may be copper, aluminum, or other metal, synthetic resin or plastic, such as a film of a polyester, a polyamide, polyimide, a polyolefin, or silicon oxide, or silicon nitride. The composition is applied such that the resist layer, after drying, is between about 0.3 and 200 microns thick, preferably between 0.5 and 2.0 microns thick.

The exposure of the composition to actinic radiation in a predetermined pattern may be achieved by exposure through a suitable image-bearing mask consisting of opaque and transparent areas. Deep ultraviolet radiation is employed in the range of 180 nm - 300 nm, preferably 200 - 280 nm, and suitable sources include deuterium arcs, mercury vapor arcs, xenon-mercury arcs, pulsed mercury arcs, xenon arcs, and various laser sources, such as the krypton-fluoride excimer laser. The exposure time required depends on several factors such as the nature of the composition employed, the thickness of the layer, the type of radiation source, and the distance of the radiation source from the layer. The exposure time is generally on the order of 10 seconds to 4 minutes, but can be readily determined by routine experimentation.

After the resist layer is image-wise exposed, a positive image can be obtained by washing with an aqueous base developer to remove the exposed areas, leaving the unexposed areas. The developer thus dissolves or renders much more easily removed the exposed areas, and gentle agitation may be employed, if necessary.

A negative image can be obtained by employment of a post-exposure bake, which effects crosslinking in the exposed areas. The temperature of this post-exposure bake is between 95°C to 160°C, most preferably 110°C - 130°C. This heating treatment may be conducted with a hot-plate system for from about 10 seconds to the time necessary to crosslink the resin. This normally ranges from about 10 seconds to about 90 seconds, preferably from about 30 seconds to about 90 seconds. The time selected depends on the choice of composition components and the substrate used. Heating also serves to diffuse the generated acid to the crosslinking compound.

Generally, the post-exposure bake time and temperature are determined and optimized for the desired properties by the end-user.

After the post-exposure bake, a deep UV flood exposure is employed to generate a sulfonic acid in the unexposed, non-image areas and thus increase the solubility of these areas in aqueous base developer.

The exposed, resist-coated substrates are next immersed in an aqueous base developer to remove the unexposed, non-image areas, leaving the exposed, image areas. Gentle agitation may be employed, if necessary.

The aqueous base developer can be an aqueous solution of a strong base such as N-methylmorpholine; however, an aqueous alkaline solution, such as one containing sodium hydroxide, sodium carbonate, sodium bicarbonate, tetramethylammonium hydroxide, or the like, is preferred. A very small amount, generally 5 - 15% by volume, or a water-soluble lower alcohol may be added to the developer solution to speed development, if necessary.

After the exposure and development steps, the substrate may be etched. There are several reasons why etching may be employed, including the desire to remove metal from the exposed areas in the formation of a printed circuit, or the desire to increase the depth of image. Suitable etching procedures are well known in the art.

## EXAMPLE 1

Preparation of O-(p-Toluenesulfonyl)-α-hydroxyiminobenzyl cyanide

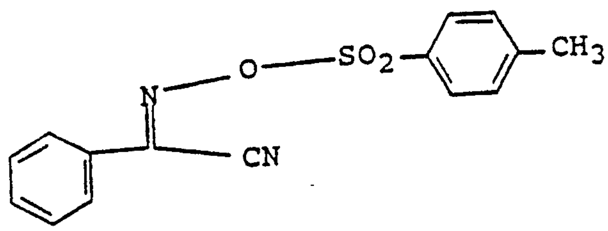

IA) α-Hydroxyiminobenzyl cyanide is prepared in 56% yield according to the procedure detailed in Org. Syn., 1979, 59, 95 mpt: 119 - 121 °C IR (KBr) νN-OH 3380 $cm^{-1}$(s); νC-N 2220 $cm^{-1}$(w).

IB) O-(p-Toluenesulfonyl)-α-hydroxyiminobenzyl cyanide A 250 ml, three-neck flask is fitted with a pressure-equalized addition funnel, a nitrogen inlet, and a ground glass stopper. The apparatus is purged with nitrogen and charged with a α-hydroxyiminobenzyl cyanide (4.0 g, 0.028 mole), methylene chloride (60 ml) an triethylamine (3.90 ml, 0.030 mole). After cooling the mixture to 0 °C, tosyl chloride (5.30 g, 0.028 mole) in methylene chloride (30 ml) is added slowly, dropwise to solution. After the addition is complete, the reaction is allowed to warm to room temperature, and stirred for 12 hours. Water (75 ml) is next added to the mixture, and the organic phase is separated and washed with cold water (2 x 100 ml) and dried over $Na_2SO_4$. After removal of solvent under reduced pressure, a pale yellow solid is obtained. Crystallization from hexane/ethyl acetate give colorless plates: 4.0 g (48%); mpt. 130 - 131 °C; IR (KBr) $^{V}$CN 2220 $cm^{-1}$ (w), $VSO_2$ 1190, 1200, 1400 $cm^{-1}$(s); 1HNMR ($CDCl_3$/Acetone-$d^6$) 88.0 - 7.49 (m, 9, aromatic), 2.47 (s, 3, $CH_3$); M+ 301 (17.8%), $^{m}$/e 129 [M-$OSO_2C_6H_4CH_3$] (100%); λmax (εm)[THF] 232 nm (7800), 268 (10,679).

## EXAMPLE II

### Preparation of O-(p-Toluenesulfonyloxy)-9-fluorenone oxime

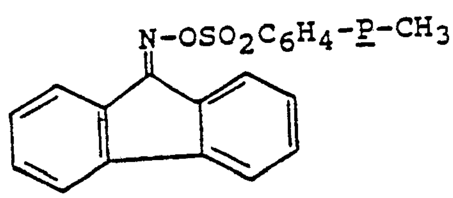

O-(p-Toluenesulfonyloxy)-9-fluorenone oxime is prepared as described in Example IB employing 9-fluorenone oxime (4.0 g, 0.020 mole) triethylamine (2.95 ml, 0.022 mole) and p-toluenesulfonyl chloride (4.20 g, 0.022 mole) in THF (100 ml). The desired product is purified by crystallization from hexane/ethyl acetate: 4.80 g (69%; mpt. 159 - 160 °C; IR (KBr) $VSO_2$ 1190, 1380 $cm^{-1}$ (s); λmax(ε m)[THF] 219 nm (16,000), 224 nm (25,600), 256 nm (31,400), 300 nm (5,200); M+ 350 (98%).

## EXAMPLE III

### Lithographic Evaluation of O-(p-Toluenesulfonyl)-α-hydroxyiminobenzylcyanide and 2,6-Dimethylol-para-cresol In Cresol-Formaldehyde Resin

IIIA) Production of a positive-tone image:

A formulation is prepared comprised of O-(p-toluenesulfonyl)-α-hydroxyiminobenzylcyanide (5% by weight), cresol-formaldehyde resin (24 % by weight), 2,6-dimethylol-para-cresol (1.2% by weight), and cyclopentanone (69.8% by weight). This formulation is spin coated onto a 3-inch silicon wafer to obtain a

film thickness of 1.4 microns, and the wafer is exposed to the full spectrum of an OAI deep ultraviolet exposure unit through a quartz optoline mask. Development with buffered, aqueous potassium hydroxide produces an excellent positive-tone image comprised of clear open areas and patterns. Photospeed: 90 mJ/cm$^2$; Contrast: 1.19.

An analogous experiment is run with a formulation prepared as above, with the exception that no photospeed enhancing 2,6-dimethylol-para-cresol additive is employed. After processing as above, this formulation produces the following data: Photospeed: 117 mJ/cm$^2$; Contrast: 1.14.

IIIB) Production of a negative-tone image (image reversal)

A formulation is prepared and processed as in Example IIIA, except that after the image-wise exposure step and before the development step, the wafer is heated at 130 °C on a hotplate for 1 minute and then flood exposed to deep UV radiation. Development with buffered, aqueous potassium hydroxide provides a quality negative-tone image comprised of clear open areas and patterns.

## EXAMPLE IV

### Lithographic Evaluation of O-(p-toluenesulfonyl)-9-fluorenone oxime with 2,6-Dimethylol-para-cresol in Cresol-Formaldehyde Resin

IVA) Production of a positive-tone image

A formulation is prepared comprised of O-(p-Toluenesulfonyl)-9-fluorenone oxime (5% by weight), cresol-formaldehyde resin (24% by weight), 2,6-dimethylol-para-cresol (1% by weight), and cyclopentanone (70% by weight). This formulation is spin-coated on to a 3" silicon wafer to produce a film thickness of 1.35 microns. The coated wafer is exposed to the full spectrum of an HTG deep ultraviolet exposure unit through a quartz optoline mask. Development with buffered, aqueous potassium hydroxide produces a quality positive image comprised of clear open areas and patterns.

IVB) Production of a negative-tone image (image reversal)

A formulation is prepared and processed as in Example IVA except that after the image-wise exposure step and before the development step the wafer is heated at 120 °C for one-half hour in a convention oven and then flood exposed to deep UV radiation. Development with buffered, aqueous potassium hydroxide provides a quality negative-tone image comprised of clear open areas and patterns.

## EXAMPLE V

### Lithographic Evaluation of O-(p-Toluenesulfonyl)-α-hydroxyiminobenzyl cyanide with 2,6-dimethylol-para-cresol in poly(3,5-dimethyl-4-hydroxystyrene-co-4-hydroxystyrene) Resin

VA) Production of a positive-tone image

A formulation is prepared comprised of O-(p-Toluenesulfonyl)-α-hydroxyiminobenzylcyanide (3% by weight), poly(3,5-dimethyl-4-hydroxystyrene-co-4-hydroxystyrene) 25% by weight), 2,6-dimethylol-para-cresol (1.2% by weight) and cyclopentanone (70.8% by weight). This formulation is spin-coated on to a 3"

silicon wafer and processed according to Example IVA to provide a quality positive-tone image comprised of clear open areas and patterns.

VA) Production of a negative-tone image (image reversal)

A formulation is prepared and processed according to Example VA except that after the image-wise exposure step and before the development step the wafer is heated at 120 °C for one minute on a hotplate and then flood exposed to deep UV radiation. Development with buffered aqueous potassium hydroxide produces a quality negative-tone image comprised of clear open areas and patterns.

## EXAMPLE VI

### Lithographic Evaluation of O-(p-toluenesulfonyl)-α-hydroxyiminobenzylcyanide with 2,6-dimethylol-para-cresol in poly(4-hydroxystyrene) Resin

VIA) Production of a positive-tone image

A formulation is prepared comprised of O-(p-toluenesulfonyl)-α-hydroxyiminobenzylcyanide (3% by weight), 2,6-dimethylol-para-cresol (1% by weight), poly(4-hydroxystyrene) (20% by weight), and cyclopentanone (76% by weight). This formulation is spin-coated on to a 3" silicon wafer and processed according to Example IVA to provide a positive-tone image comprised of clear open areas and patterns.

VIA) Production of a negative-tone image (image reversal)

A formulation is prepared and processed according to Example VIA except that after the image-wise exposure step and before the development step the wafer is heated at 130 °C for 20 minutes in a convection oven and then flood exposed to deep UV radiation. Development with buffered aqueous potassium hydroxide produces a quality negative-tone image comprised of clear open areas and patterns.

## EXAMPLE VII

A formulation is prepared comprised of O-(p-toluenesulfonyl)-α-hydroxyiminobenzylcyanide (0.13% by weight), poly(3-methyl-4-hydroxystyrene) (19.6% by weight), propylene glycol monomethylether acetate (79.3% by weight), and 2,6-dimethylol-para-cresol (1.0% by weight). The solution is spin-coated at 4500 rpm and oven baked at 90 °C for 30 minutes to substantially remove the solvent. The film is then exposed through a mask of graduated and known optical densities using 248 nm radiation and then baked on a hot plate at about 125 °C for 60 seconds. After developing in 0.3N tetramethylammonium hydroxide solution, the film thickness remaining after development (with specific exposure doses) is measured. The slope of the plot of film thickness remaining versus log exposure dose is the contrast of the resist. Under these conditions a contrast of 9 and a photospeed of 4.9 is obtained.

## EXAMPLE VIII

The formulation described in Example VII is coated, pre-baked and exposed as described in Example VII. A post-exposure bake is employed at 130 °C for 60 seconds on a hot plate. After developing in 0.3N tetramethylammonium hydroxide solution, a contrast of 16 and a photospeed of 4.5 is obtained.

## Claims

1. A photosensitive composition capable of alternatively producing positive or negative images upon imagewise exposure to activating energy, which comprises:
(a) a non-crosslinked, aqueous alkali soluble or swellable resin in an amount sufficient to bind the composition components into a uniform film when the composition is coated onto a substrate; and
(b) an oxime sulfonate ester which liberates a sulfonic acid upon exposure to sufficient activating energy, said oxime sulfonate ester being present in the composition in an amount sufficient to cause an imagewise differentiation upon imagewise exposure to sufficient activating energy; and
(c) a photospeed enhancing crosslinking agent which is present in the composition in sufficient amount to crosslink said resin in the presence of sufficient acid and heat;
said composition being substantially free of ethylenically unsaturated materials which are polymerizable by free radical initiation.

2. The composition of claim 1 wherein said resin comprises one or more components selected from the group consisting of novolaks, poly(hydroxystyrene)homopolymers, and copolymers of hydroxystyrene and $C_1$ to $C_4$ alkyl substituted hydroxystyrene.

3. The composition of claim 1 wherein the oxime sulfonate ester component comprises one or more compounds selected from the group consisting of

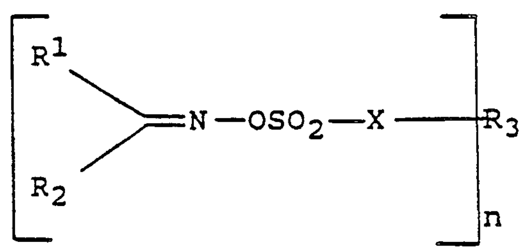

I

AND

II

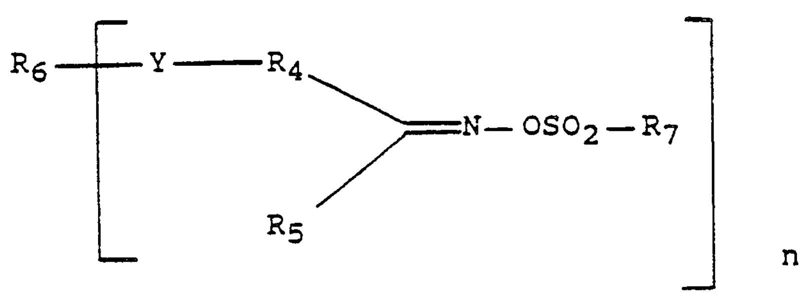

wherein
n is 1 or 2,
$R_1$ is -COO alkyl, -COO aryl or -CN, and
$R_2$ is alkyl or aryl, or phenyl substituted by $C_1$ to $C_6$ alkyl, -OH, -CN, $C_1$ to $C_4$ alkoxy, aryloxy, -COO alkyl, -COO aryl or $NO_2$; or
$R_2$ and $R_1$ together with the atom to which they are bound form a $C_5$-$C_{10}$ carbocyclic or heterocyclic ring; and
X and Y are independently selected from the group consisting of a direct bond, $-CH_2-$, or unsubstituted or substituted $C_2$-$C_5$ alkylene, and
$R_3$ is, when $n=1$, $C_1$-$C_{18}$-alkyl or phenyl which may be unsubstituted or substituted by -OH, -CN, halogen, $C_1$-$C_{12}$-alkyl,
$C_1$-$C_4$-alkoxy, or $NO_2$; or naphthyl which is unsubstituted or substituted, or $R_3$ and $R_2$ or $R_3$ and $R_1$ together with the atoms to which they are bonded form a $C_5$-$C_{12}$ heterocyclic ring, and $R_3$ is, when $n=2$, a

$(CH_2)_m$ group, wherein m is 2 to 8, or phenylene or naphthylene which are unsubstituted or substituted; and $R_4$ is arylene, substituted arylene, methylene, $C_2$-$C_6$ straight, branched, or cyclic alkylene; and
$R_5$ is cyano, or a -COO-alkyl or -COO-aryl group; and
$R_6$ is, when n = 1, a hydrogen atom, or $C_1$-$C_8$ alkyl, or phenyl, phenyl substituted with -OH, -CN, $C_1$ to $C_4$-alkoxy, aryloxy,
-COO-alkyl, -COO-aryl, $NO_2$, or halogen; or $R_5$ and $R_6$ together with the atoms to which they are bound form a $C_6$-$C_{12}$ carbocyclic or heterocyclic ring; and
$R_7$ is phenyl, unsubstituted or substituted by -OH, -CN, alkoxy, halogen, or $C_1$-$C_5$ alkyl, or $C_1$-$C_{18}$ straight or branched alkyl which may be substituted or unsubstituted; or is $C_6$-$C_{12}$ aryl, unsubstituted or substituted, or $R_7$ and $R_6$ or $R_5$ and $R_7$, together with the atoms to which they are bound, form a $C_6$-$C_{12}$ heterocyclic ring.

4. The composition of claim 1 wherein component (c) comprises a compound which has the formula
$(R_1O - CHR_3)_n - A - (CHR_4 - OR_2)_m$
wherein A has the formula B or B-Y-B, wherein B is a substituted or unsubstituted mononuclear or fused polynuclear aromatic hydrocarbon or an oxygen or sulfur containing heterocyclic compound, Y is a single bond, $C_1$-$C_4$-alkylene or -alkylenedioxy, the chains of which may be interrupted by oxygen atoms, -O-, -S-, $-SO_2-$, -CO-, $CO_2$, $-O-CO_2-$, -CONH- or phenylenedioxy, $R_1$ and $R_2$ are H, $C_1$-$C_6$-alkyl, cycloalkyl, substituted or unsubstituted aryl, alkaryl or acyl; $R_3$, $R_4$ are independently H, $C_1$-$C_4$-alkyl or substituted or unsubstituted phenyl and n ranges from 1 to 3 and m ranges from 0 to 3, provided that n + m is greater than 1.

5. The composition of claim 1 wherein the component (c) has the formula

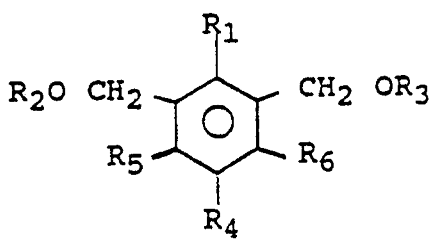

wherein $R_1$, $R_4$, $R_5$, $R_6$ are independently H, $(C_1$-$C_6)$ alkyl, $(C_3$-$C_6)$ cycloalkyl, aryl, arylalkyl or $OR_2$; and $R_2$, $R_3$ are independently H, $(C_1$-$C_6)$ alkyl, $(C_3$-$C_6)$ cycloalkyl, aryl or arylalkyl.

6. The composition of claim 1 wherein said component (c) is dimethylol paracresol or methyl methoxy diphenyl ether.

7. The composition of claim 1 wherein said component (c) is one or more compounds selected from the group consisting of benzene, 1-methoxy-2,6-bis(hydroxymethyl)-4-methyl-; phenol, 2,6-bis(methoxymethyl)-4-methyl-; and benzene, 1-methoxy-2,6-bis(methoxymethyl)-4-methyl-.

8. The composition of claim 1 further comprising a solvent.

9. The composition of claim 8 wherein said solvent component comprises one or more components selected from the group consisting of propylene glycol monoalkyl ether and propylene glycol monoalkyl ether acetate.

10. The composition of claim 1 further comprising one or more components selected from the group consisting of colorants, dyes, anti-striation agents, leveling agents, plasticizers, adhesion promoters, speed enhancers, solvents and surfactants.

11. A photosensitive article which comprises a substrate, and the composition of claim 1 coated on said substrate.

12. The article of claim 11 wherein the surface of said substrate on which the composition is coated has been treated with an adhesion promoter.

13. The article of claim 12 wherein the adhesion promoter comprises hexamethyl disilazane.

14. The article of claim 11 wherein said substrate is selected from the group consisting of silicon, aluminum, polymeric resins, silicon dioxide, doped silicon dioxide, silicon nitride, tantalum, copper, polysilicon, ceramics and aluminum/copper mixtures.

15. A method of producing positive images which comprises

I. coating a surface with a photosensitive composition, which comprises

(a) a non-crosslinked, aqueous alkali soluble or swellable resin in an amount sufficient to bind the composition components into a uniform film when the composition is coated onto a substrate; and

(b) an oxime sulfonate ester which liberates a sulfonic acid upon exposure to sufficient activating energy,

said oxime sulfonate ester being present in the composition in an amount sufficient to cause an imagewise differentiation upon imagewise exposure to sufficient activating energy; and

(c) a photospeed enhancing crosslinking agent which is present in the composition in sufficient amount to increase the effective photospeed of the composition relative to a composition without said agent;

said composition being substantially free of ethylenically unsaturated materials which are polymerizable by free radical initiation; and

II. imagewise exposing said composition to sufficient imaging energy to cause an imagewise differentiation; and

III. removing the exposed portions of said composition with an aqueous alkaline solution.

16. The method of claim 15 wherein said resin comprises one or more components selected from the group consisting of novolaks, poly(hydroxystyrene)homopolymers, and copolymers of hydroxystyrene and $C_1$ to $C_4$ alkyl substituted hydroxystyrene.

17. The method of claim 15 wherein the oxime sulfonate ester component comprises one or more compounds selected from the group consisting of

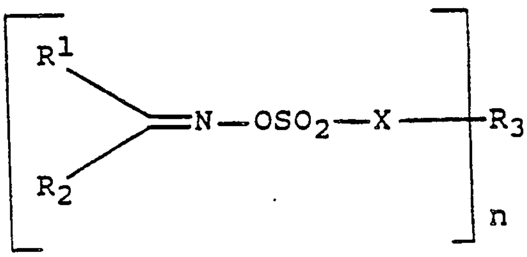

I

AND

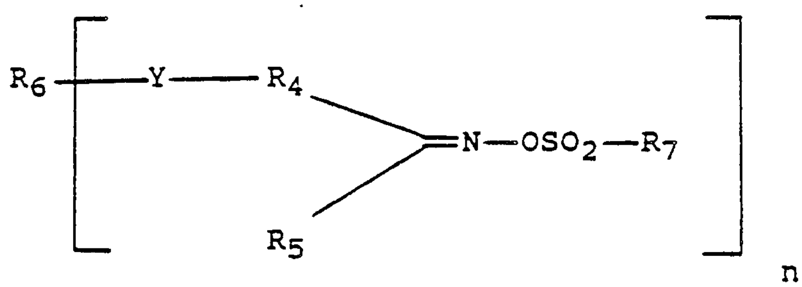

wherein

n is 1 or 2,

$R_1$ is -COO alkyl, -COO aryl or -CN, and

$R_2$ is alkyl or aryl, phenyl substituted by -OH, -CN, $C_1$ to $C_6$ alkyl, $C_1$ to $C_4$ alkoxy, aryloxy, COO-aryl, -COO-alkyl or $NO_2$,or

$R_2$ and $R_1$ together with the atom to which they are bound form a $C_5$-$C_{10}$ carbocyclic or heterocyclic ring; and

X and Y are independently selected from the group consisting of a direct bond, $-CH_2-$, or unsubstituted or substituted $C_2$-$C_5$ alkylene, and

$R_3$ is, when $n=1$, $C_1$-$C_{18}$-alkyl or phenyl which may be unsubstituted or substituted by -OH, -CN, halogen, $C_1$-$C_{12}$-alkyl,

$C_1$-$C_4$-alkoxy, or $NO_2$; or naphthyl which is unsubstituted or substituted, or $R_3$ and $R_2$ or $R_3$ and $R_1$ together with the atoms to which they are bonded form a $C_5$-$C_{12}$ heterocyclic ring, and $R_3$ is, when $n=2$, a $(CH_2)_m$ group, wherein m is 2 to 8, or phenylene or naphthylene which are unsubstituted or substituted; and

$R_4$ is arylene, substituted arylene, methylene, $C_2$-$C_6$ straight, branched, or cyclic alkylene; and

$R_5$ is cyano, or a -COO alkyl or -COO aryl group; and

$R_6$ is, when $n=1$, a hydrogen atom, or $C_1$-$C_8$ alkyl, or phenyl, phenyl substituted with -OH, -CN, $C_1$ to $C_4$ alkoxy, aryloxy,

-COO-alkyl, -COO-aryl, $NO_2$, or halogen; or $R_5$ and $R_6$ together with the atoms to which they are bound form a $C_6$-$C_{12}$ with the atoms to which they are bound form a $C_6$-$C_{12}$ carbocyclic or heterocyclic ring; and $R_7$ is phenyl, unsubstituted or substituted by -OH, -CN, alkoxy, halogen, or $C_1$-$C_5$ alkyl, or $C_1$-$C_{18}$ straight or branched alkyl which may be substituted or unsubstituted; or is $C_6$-$C_{12}$ aryl, unsubstituted or substituted, or $R_7$ and $R_6$ or $R_5$ and $R_7$, together with the atoms to which they are bound, form a $C_6$-$C_{12}$ heterocyclic ring.

18. The method of claim 15 wherein component (c) comprises a compound which has the formula

$(R_1O - CHR_3)_n - A - (CHR_4 - OR_2)_m$

wherein A has the formula B or B-Y-B, wherein B is a substituted or unsubstituted mononuclear or fused polynuclear aromatic hydrocarbon or an oxygen or sulfur containing heterocyclic compound, Y is a single bond, $C_1$-$C_4$-alkylene or -alkylenedioxy, the chains of which may be interrupted by oxygen atoms, -O-, -S-, $-SO_2-$, -CO-, $CO_2$, $-O-CO_2-$, -CONH- or phenylenedioxy, $R_1$ and $R_2$ are H, $C_1$-$C_6$-alkyl, cycloalkyl, substituted or unsubstituted aryl, alkaryl or acyl; $R_3$, $R_4$ are independently H, $C_1$-$C_4$-alkyl or substituted or unsubstituted phenyl and n ranges from 1 to 3 and m ranges from 0 to 3, provided that n + m is greater than 1.

19. The method of claim 15 further comprising one or more components selected from the group consisting of colorants, dyes, anti-striation agents, leveling agents, plasticizers, adhesion promoters, speed enhancers, solvents and surfactants.

20. The method of claim 15 wherein said substrate is selected from the group consisting of silicon, aluminum, polymeric resins, silicon dioxide, doped silicon dioxide, silicon nitride, tantalum, copper, polysilicon, ceramics and aluminum/copper mixtures.

21. The method of claim 15 wherein step II is conducted with actinic, electron beam, ion beam or x-radiation.

22. The method of claim 21 wherein step II is conducted with ultraviolet radiation of from about 180 nm to about 300 nm.

23. The method of claim 15 wherein said solution comprises one or more components selected from the group consisting of

N-methylmorpholine, an alkali metal hydroxide, carbonate or bicarbonate or tetra-alkylammonium hydroxide.

24. A method for producing negative images which comprises

I. coating a surface with a photosensitive composition which comprises

(a) a non-crosslinked, aqueous alkali soluble or swellable resin in an amount sufficient to bind the composition components into a uniform film when the composition is coated onto a substrate; and

(b) an oxime sulfonate ester which liberates a sulfonic acid upon exposure to sufficient activating energy, said oxime sulfonate ester being present in the composition in an amount sufficient to cause an imagewise differentiation upon imagewise exposure to sufficient activating energy; and

(c) a photospeed enhancing crosslinking agent which is present in the composition in sufficient amount to crosslink said resin in the presence of sufficient acid and heat;

said composition being substantially free of ethylenically unsaturated materials which are polymerizable by free radical initiation; and

II. imagewise exposing said composition to sufficient imaging energy to cause an imagewise differentiation;

and

III. heating said exposed composition at a sufficient temperature and for a sufficient amount of time to cause the acid catalyzed crosslinking of the imagewise exposed areas; and

IV. overall flood exposing the composition to sufficient activating energy to increase the solubility of the composition in the non-image areas; and

V. removing the non-imagewise exposed non-image areas of the composition with an aqueous alkaline solution.

25. The method of claim 24 wherein said resin comprises one or more components selected from the group consisting of novolaks, poly(hydroxystyrene)homopolymers, and copolymers of hydroxystyrene and $C_1$ to $C_4$ alkyl substituted hydroxystyrene.

26. The method of claim 24 wherein the oxime sulfonate ester component comprises one or more compounds selected from the group consisting of

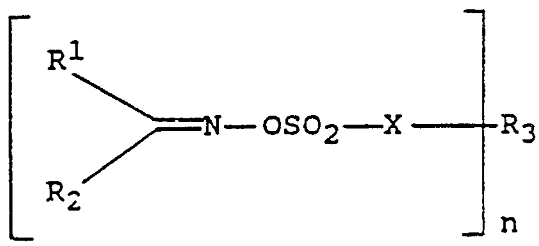

I

AND

II

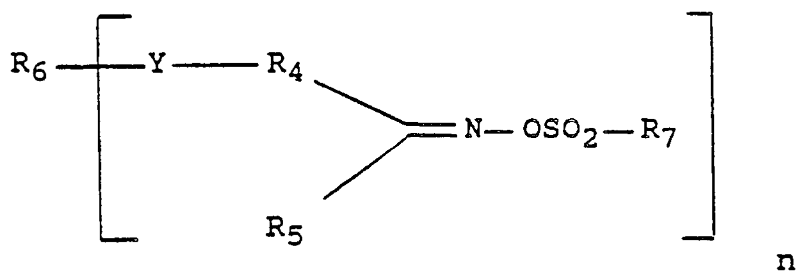

wherein
n is 1 or 2,
$R_1$ is -COO alkyl, -COO aryl or -CN, and
$R_2$ is alkyl or aryl, or phenyl substituted by -OH, -CN, $C_1$ to $C_6$ alkyl, $C_1$ to $C_4$ alkoxy, aryloxy, COO-aryl, -COO-alkyl or $NO_2$,or
$R_2$ and $R_1$ together with the atom to which they are bound form a $C_5$-$C_{10}$ carbocyclic or heterocyclic ring; and
X and Y are independently selected from the group consisting of a direct bond, $-CH_2-$, or unsubstituted or substituted $C_2$-$C_5$ alkylene, and
$R_3$ is, when $n=1$, $C_1$-$C_{18}$-alkyl or phenyl which may be unsubstituted or substituted by -OH, -CN, halogen, $C_1$-$C_{12}$-alkyl,
$C_1$-$C_4$-alkoxy, or $NO_2$; or naphthyl which is unsubstituted or substituted, or $R_3$ and $R_2$ or $R_3$ and $R_1$ together with the atoms to which they are bonded form a $C_5$-$C_{12}$ heterocyclic ring, and $R_3$ is, when $n=2$, a $(CH_2)_m$ group, wherein m is 2 to 8, or phenylene or naphthylene which are unsubstituted or substituted; and
$R_4$ is arylene, substituted arylene, methylene, $C_2$-$C_6$ straight, branched, or cyclic alkylene; and
$R_5$ is cyano, or a -COO alkyl or -COO aryl group; and
$R_6$ is, when $n=1$, a hydrogen atom, or $C_1$-$C_8$ alkyl, or phenyl, phenyl substituted with -OH, -CN, $C_1$ to $C_4$ alkoxy, aryloxy,
COO-alkyl, -COO-aryl, $NO_2$, or halogen; or $R_5$ and $R_6$ together with the atoms to which they are bound form a $C_6$-$C_{12}$ carbocyclic or heterocyclic ring; and
$R_7$ is phenyl, unsubstituted or substituted by -OH, -CN, alkoxy, halogen, or $C_1$-$C_5$ alkyl, or $C_1$-$C_{18}$ straight or branched alkyl which may be substituted or unsubstituted; or is $C_6$-$C_{12}$ aryl, unsubstituted or substituted, or $R_7$ and $R_6$ or $R_5$ and $R_7$, together with the atoms to which they are bound, form a $C_6$-$C_{12}$ heterocyclic ring.

27. The method of claim 24 wherein component (c) comprises a compound which has the formula
$(R_1O - CHR_3)_n - A - (CHR_4 - OR_2)_m$
wherein A has the formula B or B-Y-B, wherein B is a substituted or unsubstituted mononuclear or fused polynuclear aromatic hydrocarbon or an oxygen or sulfur containing heterocyclic compound, Y is a single bond, $C_1$-$C_4$-alkylene or -alkylenedioxy, the chains of which may be interrupted by oxygen atoms, -O-, -S-, $-SO_2-$, -CO-, $CO_2$,
$-O-CO_2-$, -CONH- or phenylenedioxy, $R_1$ and $R_2$ are H, $C_1$-$C_6$-alkyl, cycloalkyl, substituted or unsubstituted aryl, alkaryl or acyl; $R_3$, $R_4$ are independently H, $C_1$-$C_4$-alkyl or substituted or unsubstituted phenyl and n ranges from 1 to 3 and m ranges from 0 to 3, provided that n + m is greater than 1.

28. The method of claim 24 further comprising one or more components selected from the group consisting of colorants, dyes, anti-striation agents, leveling agents, plasticizers, adhesion promoters, speed enhancers, solvents and surfactants.

29. The method of claim 24 wherein said substrate is selected from the group consisting of silicon, aluminum, polymeric resins, silicon dioxide, doped silicon dioxide, silicon nitride, tantalum, copper, polysilicon, ceramics and aluminum/copper mixtures.

30. The method of claim 24 wherein steps II and IV are independently conducted with actinic, electron beam, ion beam or x-radiation.

31. The method of claim 30 wherein steps II and IV are independently conducted with ultraviolet radiation of from about 180 nm to about 300 nm.

32. The method of claim 24 wherein said solution comprises one or more components selected from the group consisting of
N-methylmorpholine, an alkali metal hydroxide, carbonate or bicarbonate or tetra-alkylammonium hydroxide.

33. The method of claim 24 wherein said heating step III is conducted at a temperature of from about 95° C to about 160° C for from about 10 to about 90 seconds.